# EUROPEAN PATENT SPECIFICATION

(11) **EP 0 464 810 B1**
(45) Date of publication and mention of the grant of the patent: **10.05.1995**
(21) Application number: 91111072.4
(22) Date of filing: 04.07.1991
(51) Int. Cl.: G02F 1/136, H01L 49/02

(54) **Method for producing an element substrate for a liquid crystal display device**
Verfahren zur Herstellung eines Substrates für eine Flüssigkristall-Anzeigevorrichtung
Procédé de fabrication d'un substrat pour un dispositif d'affichage à cristal liquide

(30) Priority: 06.07.1990 JP 178702/90; 27.12.1990 JP 414612/90
(43) Date of publication of application: 08.01.1992
(73) Proprietor: SEIKO EPSON CORPORATION, Shinjuku-ku Tokyo-to (JP)
(72) Inventor: Takahashi, Kotoyoshi, c/o Seiko Epson Corporation, Nagano-ken (JP); Ushiki, Takeyoshi, c/o Seiko Epson Corporation, Nagano-ken (JP)
(74) Representative: Hoffmann, Eckart, Dipl.-Ing.

(56) References cited:
- US-A- 4 683 183
- PATENT ABSTRACTS OF JAPAN vol. 10, no. 369 (P-525), 10 December 1986 ; & JP-A-61 162 048
- PATENT ABSTRACTS OF JAPAN vol. 8, no. 18 (P-250), 26 January 1984 ; & JP-A-58 178 320
- PATENT ABSTRACTS OF JAPAN vol. 8, no. 97 (P-272), 8 May 1984 ; & JP-A-59 009 635
- CONF. RECORD OF THE 1988 INT. DISPLAY RESEARCH CONFERENCE, October 1988, pp. 226-229 ; R.L. WISNIEFF et al. : "A Lift-Off Process To Build Edge Junction MIM Active Device"
- JAPAN DISPLAY 1983, pp. 404-407 ; S. MOROZUMI et al. : "A 250 x 250 Element LCD Addressed By Lateral MIM"

## Description

The invention concerns a method for producing an element substrate on which non-linear devices are arranged in a matrix pattern in correlation with the display screen of a liquid crystal display device.

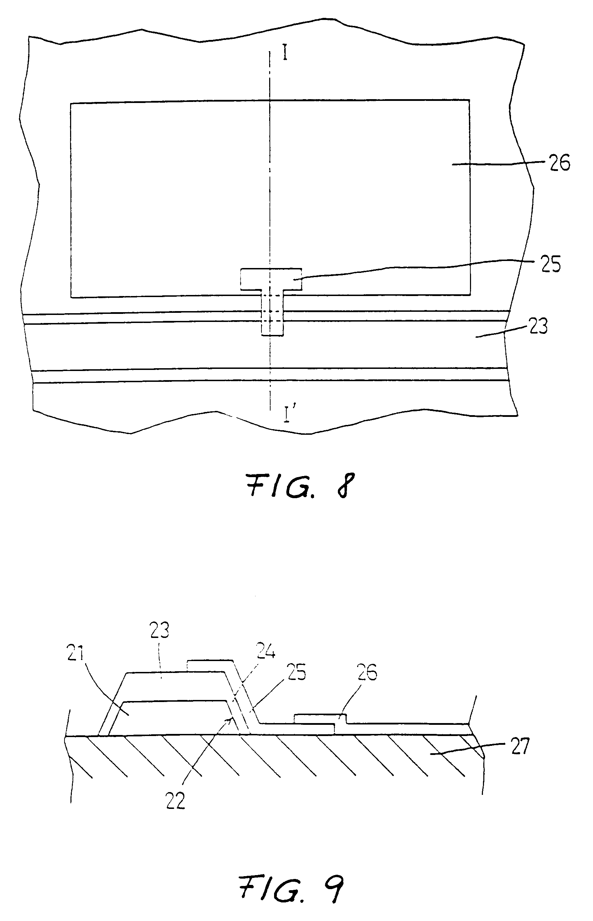

Fig. 8 shows a partial top view of an element substrate of the prior art in which metal insulator metal (MIM) devices are used for driving the pixels of a display device. Fig. 9 is a cross sectional view along line I-I′ in Fig. 8. A first conductor 21 formed on a transparent substrate 27 is covered by a barrier layer 23 except for the side portion 22 which is covered by an insulator 24. The barrier layer is an insulator whose electrical resistance is so high that it is unsuitable as an insulator of an MIM device. A second conductor 25 is formed on the insulator 24 extending over the barrier layer 23 at one end and to the substrate 27 at the other end. A pixel electrode 26 formed on the substrate 27 is connected to the second conductor 25. Only the lateral portion 22, 24, 25 of the structure shown in Fig. 9 forms the non-linear MIM device used for driving the pixel electrode 26 of the liquid crystal display device.

Due to this structure the surface area of the MIM device can be quite small. This technology is suitable for achieving a high density and high level of minuteness in a liquid crystal display device using MIM devices for driving the pixels.

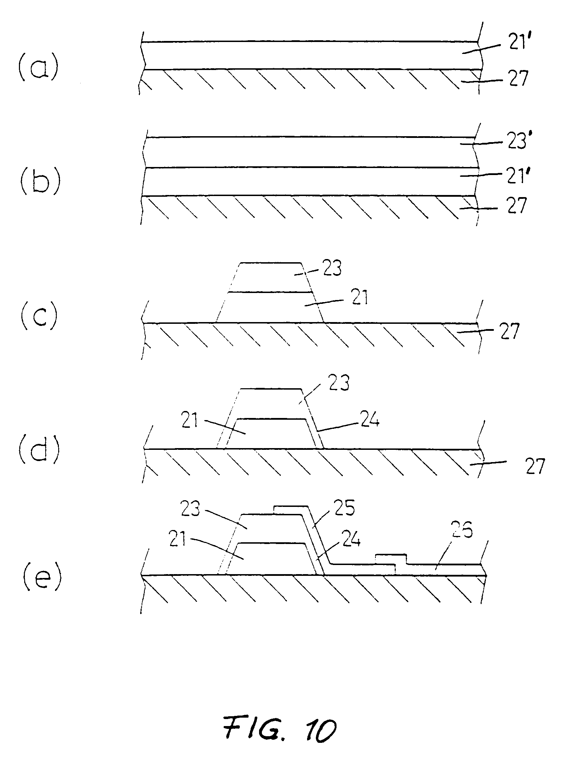

Fig. 10 shows process steps for manufacturing the prior art element substrate of Figs. 8 and 9.

In step (a) a film 21′ for the first conductor 21 is formed on the transparent substrate 27. (This includes the formation of a transparent base film.) In step (b) a barrier layer 23′ is formed on top of the film 21′. In step (c) patterning is performed by simultaneous photo-etching of the first film 21′ and the barrier layer 23′ resulting in the first conductor 21 and the barrier layer 23 forming a first insulator. In step (d) a second insulator (film) is formed on the side of the first conductor 21. In step (e) the second conductor 25 and the pixel electrode 26 are each formed and patterned.

The main portions of the first conductor 21, the second insulator 24 and the second conductor 25 will form the MIM device.

Ta, Al, Au, ITO, NiCr+Au and ITO+Cr are known as materials for the conductors of an MIM device. Materials for the second insulator that are well known are TaOx, SiOx, SiNx, SiOxNy, TaNx and ZnOx. The second insulator is formed through thermal oxidation, anodic oxidation or through another process such as sputtering.

For the barrier layer, in addition to the inorganic materials used for the second insulator, the use of organic materials such as polyimide is also known.

The best materials known for an MIM device are Ta (tantalum) for the first conductor 21, TaOx (tantalum oxide for the second insulator 24 and Cr (chromium) for the second conductor 25, i.e. a Ta/TaOx/Cr structure.

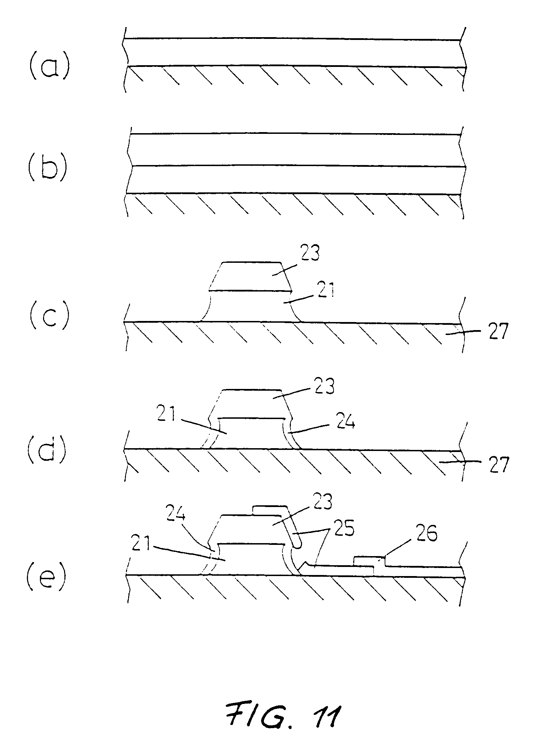

A problem involved in the prior art explained above is that the yield is extremely low making the device impractical. This will be explained in more detail with reference to Fig. 11.

Steps (a) through (e) in Fig. 11 correspond to steps in (a) through (e) in Fig. 10. When etching takes place at step (c), in general, an oxide or nitride barrier layer 23 has a lower etching rate than the first conductor 21. In case of Ta and TaOx the etching rate of TaOx is about half that of Ta. In the case of TaNx, the difference in the etching rates is even greater. As the result of the different etching rates, as shown in step in (c) in Fig. 11 the first conductor 21 takes an overhang shape. In subsequent step (d), the second insulator 24 (TaOx) is formed and in step (e) the second conductor 25 (Cr) and the pixel electrode 26 are formed. As indicated in Fig. 11(e), due to the overhang shape of the first conductor 21, a disconnection in the second conductor 25 may occur. However, even if there is no such disconnection, another problem is that the surface area of the lateral MIM device cannot be controlled because the shape (taper) of the sides the first conductor 21 cannot be controlled.

Not being able to control the surface area of the MIM device means that the display condition of the pixels of the liquid crystal display device cannot be controlled, and this is a fatal defect. Thus, as mentioned above, the problem of the prior art method is an extremely poor production yield as well as impracticability.

Methods of producing MIM devices on substrates are disclosed by JP-A-61 162 048 and JAPAN DISPLAY 1983, pages 404-407 ; S.MOROZUMI et al.: "A 250x250 element LCD addressed by lateral MIM.

The invention is intended to solve the above explained problem of the prior art and its object is to provide a method for producing an element substrate for a liquid crystal display device achieving high yields.

This object is solved with methods as claimed in the independent claims.

A further specific embodiment of the invention is claimed in the dependent claim.

Specific embodiments of the invention will be explained below with reference to the drawings, in which:
- Fig. 1: shows process steps for explaining a first embodiment of the invention,
- Fig. 2: is an illustration of details regarding the first embodiment of the invention,
- Fig. 3: shows process steps for explaining a second embodiment of the invention,
- Fig. 4: is an illustration of details regarding the second embodiment of the invention,
- Figs. 5 and 6: are illustrations for explaining a third embodiment of the invention,
- Fig. 7: is an illustration for explaining a fourth embodiment of the invention,
- Fig. 8: is a partial top view of a prior art element substrate of a liquid crystal display device,
- Fig. 9: is a cross sectional view along line I-I′ in Fig. 8 and
- Figs. 10 and 11: show process steps of a method according to the prior art.

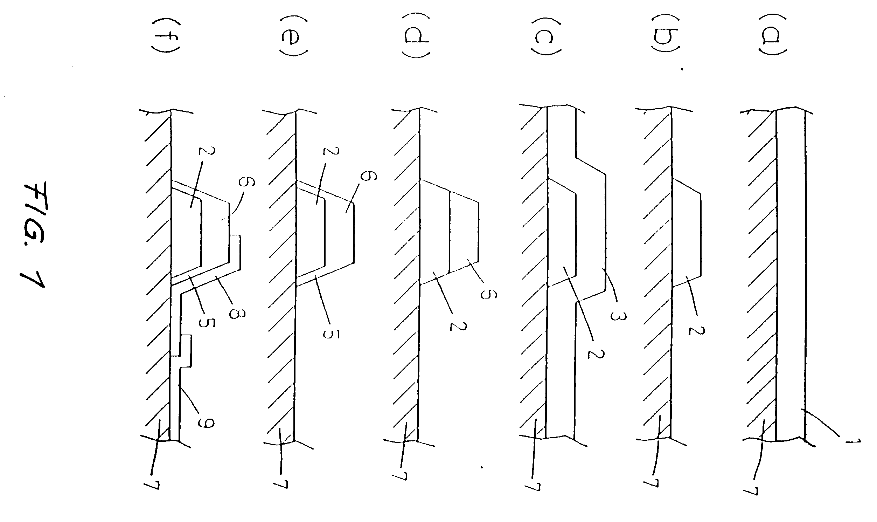

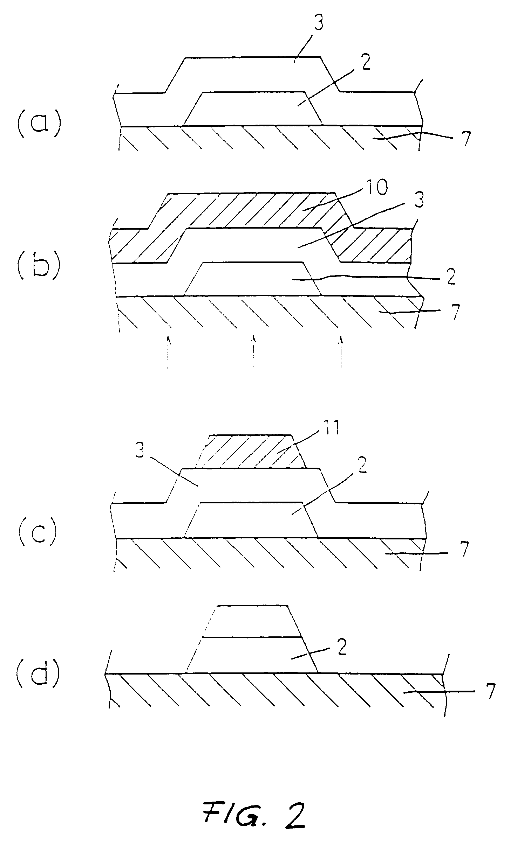

A first embodiment of the invention will now be explained with reference to Figs. 1 and 2. Steps (a) through (f) in Fig. 1 are the basic steps to give a general description of the process.

In step (a) a Ta film 1 is applied to a transparent substrate 7. Substrate 7 has a transparent base layer of TaOx on it which is not shown in the drawing.

In step (b) a Ta electrode 2 is formed from the Ta film 1 by photo-etching. Then, in step (c), a TaOx layer 3 is applied as a barrier layer to the top of the substrate 7 and the electrode 2. This is done by a sputtering or a CVD (chemical vapor deposition) process. The same applies where the barrier layer is made of a material other than TaOx (for example, TaNx or SiNx).

In step (d) the barrier layer 3 is photo-etched to leave only the portion 6 which is on top of the electrode 2 as the barrier layer. In step (e) a thin TaOx layer 5 is formed as insulating layer of the electrode 2 using anodic oxidation or thermal oxidation. Next, in step (f) the second electrode 8 made of Cr and the pixel electrode 9 are formed and patterned by means of photo-etching.

Step (d) in Fig. 1 is an important step of the invention that will be described in more detail with reference to Fig. 2. Fig. 2(a) corresponds to Fig. 1(c), namely it shows the result of step (c) in Fig. 1. A positive photoresist 10 is applied to the surface above the electrode 2 as indicated in Fig. 2(b). Next, light exposure is performed from the back side of the transparent substrate 7 (in the direction of the arrows), i.e. from the side of the transparent substrate 7 opposite to the side where the films have been applied.

As a result of this, only the positive photoresist on top of the Ta electrode 2 which is not transparent, is not exposed to the light, whereas the other portions of the positive photoresist are exposed because the oxide film or nitride film 3 such as TaOx is transparent to the light exposure. Therefore, when the resist is developed, as shown in step (c) in Fig. 2, only the resist on top of the electrode 2 will remain as resist 11. Under this condition if etching is performed until the sides of the Ta electrode 2 are exposed, the structure will become as indicated (d) in Fig. 2.

As will be appreciated, this is a result different from that resulting from step (c) in Fig. 11. The reason is that the etched film is the TaOx film 3 which is spread over the entire substrate 7. Therefore, the etching rate is uniform. Thus, etching can take place in such a manner that the sides of the electrode 2 do not have an overhang shape. In addition, the tapered shape of the sides of the electrode 2 has been formed in step (b) of Fig. 1, allowing a uniform and excellent side taper to be obtained. There is no danger that a disconnection or the Cr electrode 8 at the side of the electrode 2 will occur. As shown in Fig. 1 (f) the described method allows for a uniformity of the lateral MIM element surface area that is formed from the stacked portions of Ta electrode 2, TaOx layer 5 and Cr pattern 8.

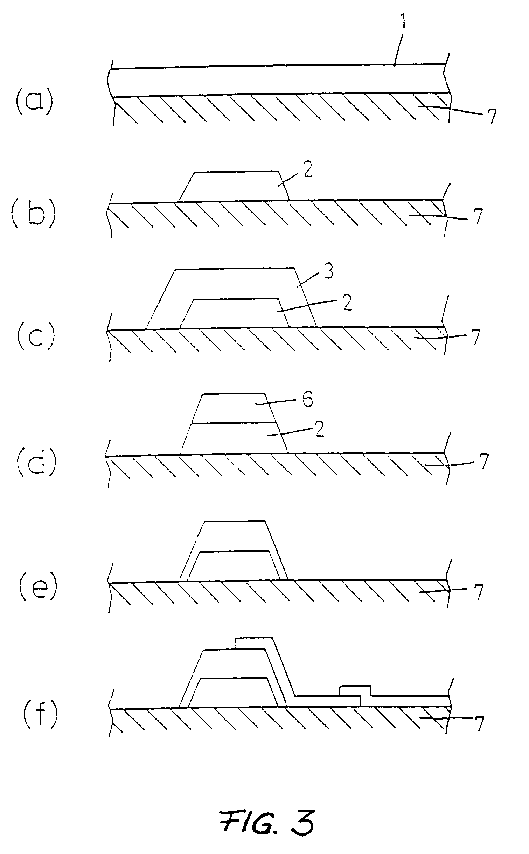

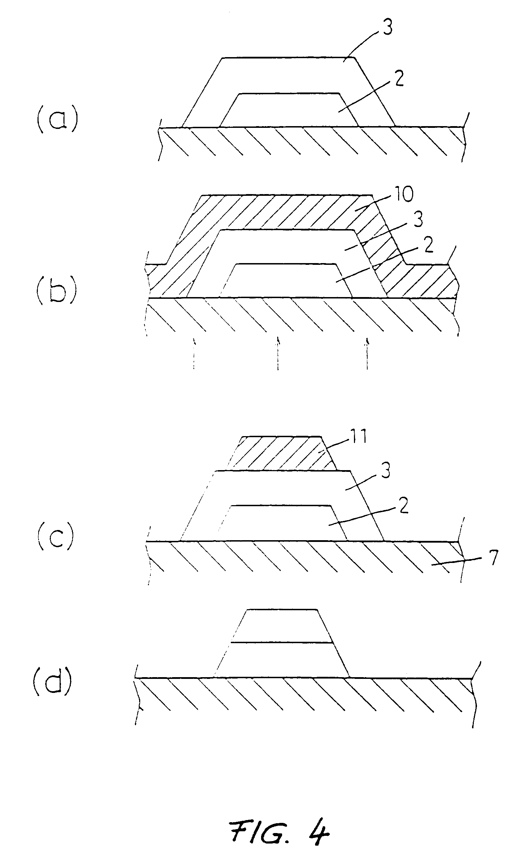

Figs. 3 and 4 illustrate a second embodiment of the invention. Fig. 3 shows the general process steps (a) to (f) and Fig. 4 shows in more details the steps (c) and (d) of Fig. 3 which are the characteristic steps of this embodiment.

Steps (a) and (b) of this embodiment according to Fig. 3 are the same as steps in (a) and (b) in Fig. 1.

In the first embodiment illustrated in Fig. 1, in step (c) TaOx layer 3 was applied as a barrier layer the whole upper surface of the transparent substrate 7 and the Ta electrode 2. However, in this second embodiment, as shown in Fig. 3(c) a TaOx barrier layer 3 is applied to the top and sides of the Ta electrode 2 only, i.e. it is not applied to the transparent substrate 7. In this case, if the TaOx barrier layer 3 is formed by means of anodic oxidation or thermal oxidation, it can be formed much cheaper than if it were formed by sputtering or CVD.

In step (d) of Fig. 3 the barrier layer 3 is removed from the sides of electrode 2 leaving only the portion 6 of the barrier layer on the top surface of electrode 2. The way this is achieved is explained in detail with reference to steps (a) through (d) of Fig. 4. Basically, this is the same method as that of Fig. 2, namely a positive photoresist 10 is applied as shown in Fig. 4(b) and exposed to light from the back surface of the transparent substrate 7. As indicated in Fig. 4 after developing the resist 10, it is only the portion 11 of the resist that remains on the top of the electrode 2. In step (d) the TaOx barrier layer 3 is etched. However, because the transparent substrate 7 has a strong resistance to the etching of the TaOx barrier layer, in essence, the only film that will be etched is the TaOx film. Therefore, the same result as with the first embodiment of Figs. 1 and 2 will be achieved and no disconnection of the Cr pattern (second electrode) on the sides of the Ta electrode 2 will occur.

As will be clear from the above description of the first and second embodiments the barrier layer needs to be transparent to the wavelength of the back light exposure. With a non-transparent barrier layer the portions of the photoresist on the sides of the barrier layer could not be exposed to light so that the resist would remain on the top and the sides of the barrier layer. As materials for transparent barrier layers there are inorganic materials such as TaOx, CrOx, SiNx, TaNx, TaOxNx and SiOxNx. However, there are also organic materials for instance polyimide. The general methods of applying a film are CVD, sputtering, vapor deposition, anodic oxidation, spin coating, dipping etc. The appropriate method has to be chosen according to the circumstances.

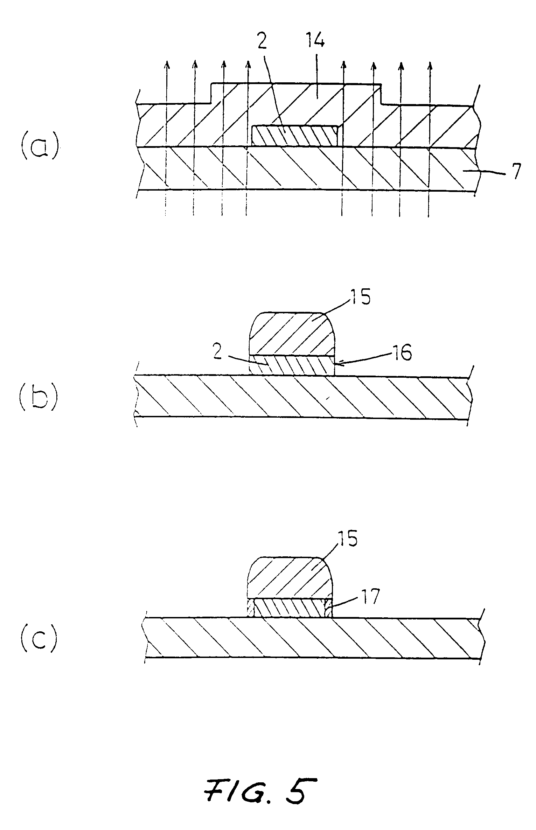

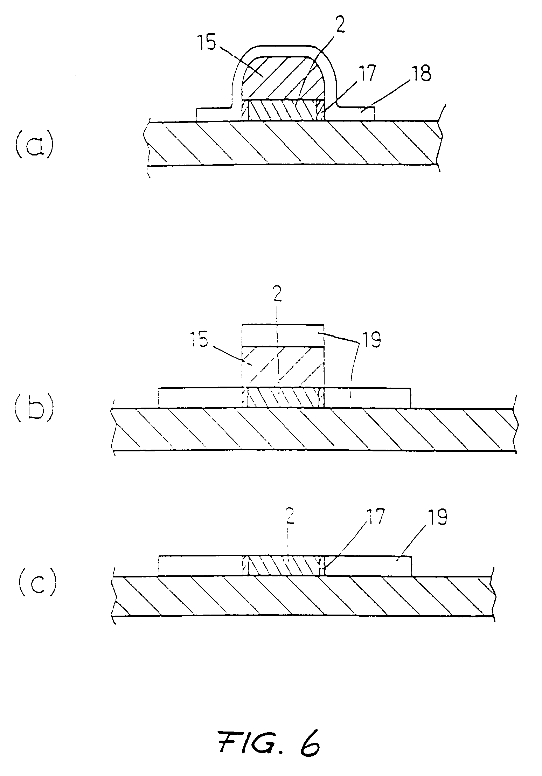

Figs. 5(a) to (c) and 6(a) illustrate a third embodiment of the invention. In this embodiment a positive photosensitive insulator (resist) is used for the barrier layer. Compared to the above embodiments, this method has the advantage of even fewer process steps. Fig. 5(a) is a cross-sectional view showing positive sensitivity polyimide 14 applied to the top of Ta electrode 2 and transparent substrate 7. In this condition, if light exposure from the back surface of the substrate in the direction of the arrows is performed, an inorganic insulator 15 will remain on top of the Ta electrode 2 after the resist has been developed. Because the sides 16 of Ta electrode 2 which are not tapered in this embodiment are exposed, anodic oxidation takes place to form TaOx layer 17, as shown in Fig. 5(c). After this, by applying a Cr pattern electrode, the MIM element is formed by means of Ta electrode 2, TaOx layer 17 and Cr pattern electrode 18, as shown in Fig. 6(a). Alternatively, starting with the result of the step according to Fig. 5(b), after anodic oxidation, the second conductor layer, layer 19, is formed as shown in Fig. 6(b). After this, the resist is removed and an element is formed by means of Ta electrode 2, TaOx layer 17 and conductor 19, as shown in Fig. 6(c). If controlling the film thickness distribution of second conductor 19 provides appropriate accuracy, adjustments may be made to the thickness of second conductor layer 19.

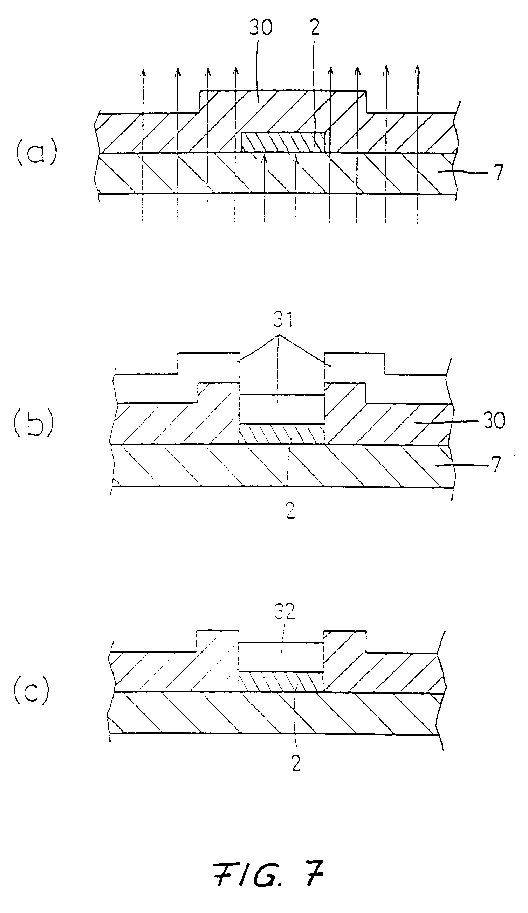

Fig. 7 illustrates a fourth embodiment of the invention using a negative photoresist. As with the third embodiment, the sides of Ta electrode 2 are not tapered. As indicated in Fig. 7(a), a negative photoresist 30 is spread evenly over the Ta electrode 2 and the transparent substrate 7. After this, light exposure from the back side of the substrate in the direction of the arrows is performed and, after developing the resist, it will remain in the areas other than that above Ta electrode 2. Then, an insulation layer 31 is formed for instance by sputtering, as shown in Fig. 7(b). When the remaining portion of the resist is subsequently removed, the same structure as that shown in Fig. 5(b) will be obtained. Instead of step (b) in Fig. 7, an insulation layer 32 can be formed on TA electrode 2 by anodic oxidation according to step (c) in Fig. 7. After removing the resist 30, the structure of Fig. 5(b) would result as with the foregoing alternative.

## Claims

1. A method of producing an element substrate for a liquid crystal display device having on a transparent substrate (7) an MIM device comprising a first conductor (2), an insulator (5) formed on at least one side of the first conductor and a second conductor (8) formed on said insulator (5), said MIM device being used to drive a pixel electrode (9) of said liquid crystal display device, said method comprising the steps
1) forming said first conductor (2) on a front side of said substrate (7),
2) forming a transparent insulator (3) on the top and the sides of the first conductor (2),
3) forming a positive photoresist (10) on the transparent insulator (3) above the first conductor (2) such that the photoresist occupies an area larger than that occupied by the first conductor (2) on the substrate,
4) exposing the photoresist to light from the back side of the substrate (7) through the substrate and the transparent insulator (3),
5) developing the photoresist,
6) etching the transparent insulator (3) until the sides of the first conductor (2) are exposed, and
7) removing the remaining photoresist and forming the insulator (5) and the second electrode (8) of the MIM device.

2. The method according to claim 1, wherein in step 2) the transparent insulator is formed on the top and the sides of the first conductor and on the substrate.

3. A method of producing an element substrate for a liquid crystal display device having on a transparent substrate (7) an MIM device comprising a first conductor (2), an insulator (17) formed on at least one side of the first conductor and a second conductor (19) formed on said insulator (17), said MIM device being used to drive a pixel electrode of said liquid crystal display device, said method comprising the steps
1) forming said first conductor (2) on a front side of said substrate (7),
2) forming a positive photoresist (14) on the top and the sides of the first conductor (2),
3) exposing the photoresist to light from the back side of the substrate (7) through the substrate,
4) developing the photoresist and etching off the exposed portion of the photoresist, whereby the sides of the first conductor (2) are exposed, and
5) forming the insulator (17) and the second electrode (19) of the MIM device.

4. A method of producing an element substrate for a liquid crystal display device having on a transparent substrate (7) an MIM device comprising a first conductor (2), a first insulator formed on at least one side of the first conductor and a second conductor formed on said insulator, said MIM device being used to drive a pixel electrode of said liquid crystal display device, said method comprising the steps
1) forming said first conductor (2) on a front side of said substrate (7),
2) forming a negative photoresist (30) on the top and the sides of the first conductor (2),
3) exposing the photoresist to light from the back side of the substrate (7) through the substrate,
4) developing the photoresist and etching off the unexposed portion of the photoresist, whereby the top of the first conductor (2) is exposed,
5) forming in sequence a second insulator (31, 32) on the exposed top of the first conductor, and
6) removing the remaining photoresist and forming the first insulator and the second electrode on the side of the first conductor (2).

## Patentansprüche

1. Verfahren zur Herstellung eines Elementsubstrats für eine Flüssigkristallanzeigevorrichtung, die auf einem transparenten Substrat (7) eine MIM-Vorrichtung umfassend einen ersten Leiter (2), einen auf wenigstens einer Seite des ersten Leiters ausgebildeten Isolator (5) und einen auf dem Isolator (5) ausgebildeten zweiten Leiter (8) aufweist, wobei die MIM-Vorrichtung zur Ansteuerung einer Pixelelektrode (9) der Flüssigkristallanzeigevorrichtung verwendet wird und das Verfahren die Schritte umfaßt:
1) Ausbilden des ersten Leiters (2) auf einer Vorderseite des Substrats (7),
2) Ausbilden eines transparenten Isolators (3) an der Oberseite und den Seiten des ersten Leiters (2),
3) Ausbilden eines Positiv-Photoresists (10) auf dem transparenten Isolator (3) über dem ersten Leiter (2) derart, daß der Photoresist eine Fläche einnimmt, die größer ist als die von dem ersten Leiter (2) auf dem Substrat eingenommene,
4) Belichten des Photoresists mit Licht von der Rückseite des Substrats (4) durch das Substrat und den transparenten Isolator (3),
5) Entwickeln des Photoresists,
6) Ätzen des transparenten Isolators (3) bis die Seiten des ersten Leiters (2) freigelegt sind, und
7) Entfernen des verbliebenen Photoresists und Ausbilden des Isolators (5) und der zweiten Elektrode (8) der MIM-Vorrichtung.

2. Verfahren nach Anspruch 1, bei dem im Schritt 2) der transparente Isolator auf der Oberseite und den Seiten des ersten Leiters und auf dem Substrat ausgebildet wird.

3. Verfahren zur Herstellung eines Elementsubstrats für eine Flüssigkristallanzeigevorrichtung, die auf einem transparenten Substrat (7) eine MIM-Vorrichtung umfassend einen ersten Leiter (2), einen auf wenigstens einer Seite des ersten Leiters ausgebildeten Isolators (17) und einen auf dem Isolator (17) ausgebildeten zweiten Leiter (19) aufweist, wobei die MIM-Vorrichtung zur Ansteuerung einer Pixelelektrode der Flüssigkristallanzeigevorrichtung verwendet wird und das Verfahren die Schritte umfaßt:
1) Ausbilden des ersten Leiters (2) auf einer Vorderseite des Substrats (7),
2) Ausbilden eines Positiv-Photoresists (14) auf der Oberseite und den Seiten des ersten Leiters (2),
3) Belichten des Photoresists mit Licht von der Rückseite des Substrats (7) durch das Substrat hindurch,
4) Entwickeln des Photoresists und Wegätzen des belichteten Abschnitts des Photoresists, wodurch die Seiten des ersten Leiters (2) freigelegt werden, und
5) Ausbilden des Isolators (17) und der zweiten Elektrode (19) der MIM-Vorrichtung.

4. Verfahren zur Herstellung eines Elementsubstrats für eine Flüssigkristallanzeigevorrichtung, die auf einem transparenten Substrat (7) eine MIM-Vorrichtung umfassend einen ersten Leiter (2), einen auf wenigstens einer Seite des ersten Leiters ausgebildeten ersten Isolator und einen auf dem Isolator ausgebildeten zweiten Leiter aufweist, wobei die MIM-Vorrichtung zur Ansteuerung einer Pixelelektrode der Flüssigkristallanzeigevorrichtung verwendet wird und das Verfahren die Schritte umfaßt:
1) Ausbilden des ersten Leiters (2) auf einer Vorderseite des Substrats (7),
2) Ausbilden eines Negativ-Photoresists (30) auf der Oberseite und den Seiten des ersten Leiters (2),
3) Belichten des Photoresists mit Licht von der Rückseite des Substrats (7) durch das Substrat hindurch,
4) Entwickeln des Photoresists und Wegätzen der unbelichteten Teile des Photoresists, wodurch die Oberseite des ersten Leiters (2) freigelegt wird,
5) Ausbilden in der Folge eines zweiten Isolators (31, 32) auf der freigelegten Oberseite des ersten Leiters, und
6) Entfernen des verbliebenen Photoresists und Ausbilden des ersten Isolators und der zweiten Elektrode auf der Seite des ersten Leiters (2).

## Revendications

1. Un procédé de fabrication d'un substrat pour un dispositif de visualisation à cristal liquide comportant, sur un substrat transparent (7), un dispositif MIM comprenant un premier conducteur (2), un isolant (5) formé sur au moins un flanc du premier conducteur, et un second conducteur (8) formé sur l'isolant (5), ce dispositif MIM étant utilisé pour attaquer une électrode de pixel (9) du dispositif de visualisation à cristal liquide, ce procédé comprenant les étapes suivantes :
1) on forme le premier conducteur (2) sur une face avant du substrat (7),
2) on forme un isolant transparent (3) sur la face supérieure et sur les flancs du premier conducteur (2),
3) on forme une couche de matière de réserve photosensible positive (10) sur l'isolant transparent (3), au-dessus du premier conducteur (2), de façon que la matière de réserve photosensible occupe une étendue supérieure à celle qu'occupe le premier conducteur (2) sur le substrat,
4) on expose la matière de réserve photosensible à de la lumière par la face arrière du substrat (7), à travers le substrat et l'isolant transparent (3),
5) on développe la matière de réserve photosensible,
6) on attaque l'isolant transparent (3) jusqu'à ce que les flancs du premier conducteur (2) soient à nu, et
7) on enlève la matière de réserve photosensible restante et on forme l'isolant (5) et la seconde électrode (8) du dispositif MIM.

2. Le procédé selon la revendication 1, dans lequel à l'étape (2) on forme l'isolant transparent sur la face supérieure et sur les flancs du premier conducteur et sur le substrat.

3. Un procédé de fabrication d'un substrat pour un dispositif de visualisation à cristal liquide comportant, sur un substrat transparent (7), un dispositif MIM comprenant un premier conducteur (2), un isolant (17) formé sur au moins un flanc du premier conducteur et un second conducteur (19) formé sur l'isolant (17), ce dispositif MIM étant utilisé pour attaquer une électrode de pixel du dispositif de visualisation à cristal liquide, ce procédé comprenant les étapes suivantes :
1) on forme le premier conducteur (2) sur une face avant du substrat (7),
2) on forme une couche de matière de réserve photosensible positive (14) sur la face supérieure et sur les flancs du premier conducteur (2),
3) on expose la matière de réserve photosensible à de la lumière, par la face arrière du substrat (7), à travers le substrat,
4) on développe la matière de réserve photosensible et on enlève par attaque la partie exposée de la matière de réserve photosensible, ce qui a pour effet de mettre à nu les flancs du premier conducteur (2), et
5) on forme l'isolant (17) et la seconde électrode (19) du dispositif MIM.

4. Un procédé de fabrication d'un substrat pour un dispositif de visualisation à cristal liquide comportant, sur un substrat transparent (7), un dispositif MIM comprenant un premier conducteur (2), un premier isolant formé sur au moins un flanc du premier conducteur et un second conducteur formé sur l'isolant, ce dispositif MIM étant utilisé pour attaquer une électrode de pixel du dispositif de visualisation à cristal liquide, ce procédé comprenant les étapes suivantes :
1) on forme le premier conducteur (2) sur une face avant du substrat (7),
2) on forme une couche de matière de réserve photosensible négative (30) sur la face supérieure et sur les flancs du premier conducteur (2),
3) on expose la matière de réserve photosensible à de la lumière, par la face arrière du substrat (7), à travers le substrat,
4) on développe la matière de réserve photosensible et on enlève par attaque la partie non exposée de la matière de réserve photosensible, ce qui a pour effet de mettre à nu la face supérieure du premier conducteur (2),
5) on forme ensuite un second isolant (31, 32) sur la face supérieure à nu du premier conducteur, et
6) on enlève la matière de réserve photosensible restante et on forme le premier isolant et la seconde électrode sur le flanc du premier conducteur (2).
